# DEMANDE DE BREVET EUROPEEN

(11) **EP 0 951 161 A1**
(43) Date de publication de la demande: **20.10.1999**
(21) Numéro de dépôt: 99201097.5
(22) Date de dépôt: 07.04.1999
(51) Int. Cl.: H04M 1/02

(54) **Dispositif de contact entre un écran à christaux liquides et un circuit imprimé**

(30) Priorité: 16.04.1998 FR 9804729
(71) Demandeur: Koninklijke Philips Electronics N.V., 5621 BA Eindhoven (NL)
(72) Inventeur: Flegeo, Arnaud, 75008 Paris (FR)
(74) Mandataire: Chaffraix, Jean

(57) **Abrégé**

L'invention concerne un dispositif pour établir le contact électrique entre un écran à cristaux liquides (110) et un circuit imprimé (102) d'un équipement électronique.

Il est connu de l'art antérieur d'utiliser des contacts Zebra (contacts sans soudure au moyen de bandes élastomères, constituées d'une alternance de sections conductrices et de sections isolantes, et placée entre l'écran et le circuit imprimé).

L'invention consiste à utiliser la nappe élastomère (103) dans laquelle sont moulées les touches (104) de l'équipement pour réaliser un tel contact. Pour cela, une languette (150) est formée dans la nappe élastomère de l'équipement. Cette languette est dotée de pistes de contact (155) sur sa face arrière (152). Lorsque la languette est pliée vers l'écran, ses pistes de contact touchent donc d'une part la zone de contact (160) du circuit intégré, et d'autre part celle de l'écran (140).

Application: Electronique grand public, téléphonie mobile notamment.

## Description

L'invention concerne un équipement électronique comportant un écran à cristaux liquides, un circuit imprimé et un dispositif de contact électrique entre ledit écran et ledit circuit imprimé. L'invention concerne également un dispositif destiné à établir un contact électrique entre un écran à cristaux liquides et un circuit imprimé d'un équipement électronique doté de touches, et une nappe en matière élastique dans laquelle sont moulées des touches, et qui est destinée à être utilisée dans un équipement électronique qui comporte un écran et un circuit imprimé reliés par un dispositif de contact électrique.

L'invention a d'importantes applications dans le domaine de l'électronique grand public, notamment dans les appareils téléphoniques.

De tels équipements sont notamment décrits dans le paragraphe "Connecting Techniques" pages 27 et 28 du manuel intitulé "Data Handbook: Liquid Crystal Displays and Driver ICs for LCD" et portant la référence "LCD01 - 1991" publié par Philips Components en juillet 1990.

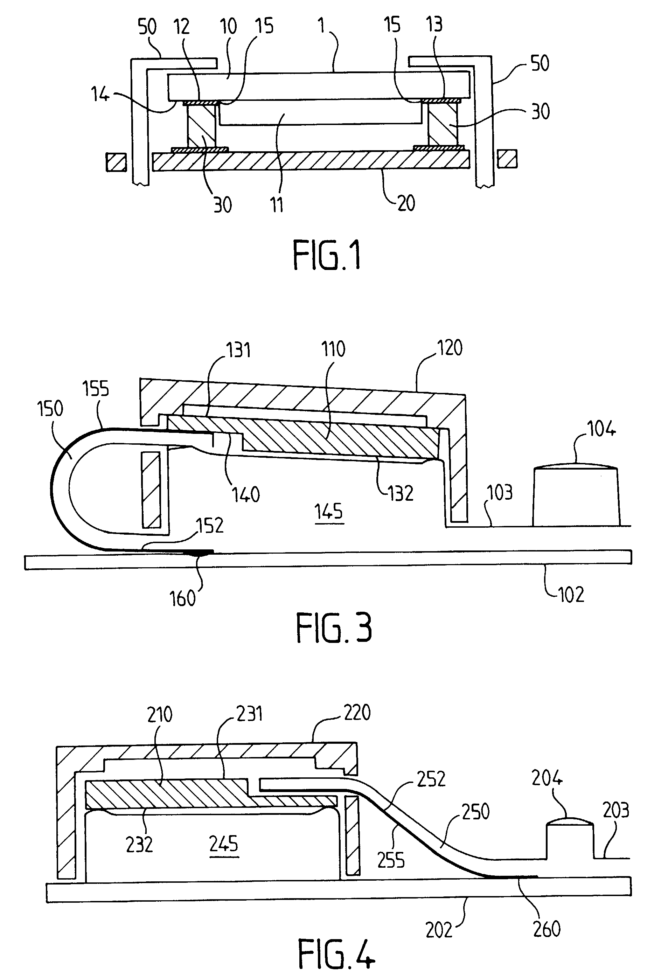

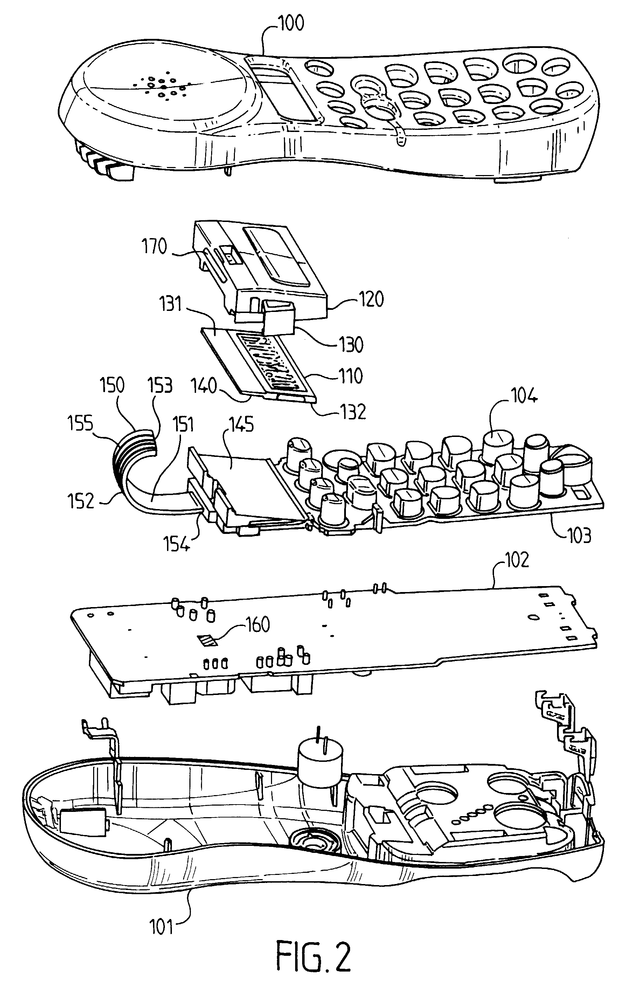

Comme indiqué dans ce document, il est courant d'utiliser comme dispositif de contact deux bandes élastomères constituées d'une alternance de sections conductrices et de sections isolantes, qui supportent l'écran et le connecte électriquement au circuit imprimé (de telles bandes sont également connues sous le nom de contact Zebra). Un tel dispositif de contact selon l'art antérieur est représenté à titre d'exemple sur la figure 1. L'écran 1 comporte un verre supérieur 10 et un verre inférieur 11. Le verre supérieur 10 déborde par rapport au verre inférieur 11 dégageant ainsi deux bandes 12 et 13 sur sa face inférieure 14. Ces deux bandes portent les contacts 15 de l'écran 1. Ces contacts 15 sont connectés au circuit imprimé 20 par les sections conductrices 30 de deux bandes élastomères. Le contact est assuré par un dispositif 50 qui est un dispositif mécanique de pression entre l'écran 1, le dispositif de contact, et le circuit imprimé 20.

De tels dispositifs offrent entière satisfaction mais sont d'un coût relativement élevé. L'invention a pour but de proposer un équipement dont le dispositif de contact soit d'un coût beaucoup plus faible.

Pour cela un équipement selon l'invention est caractérisé en ce qu'il comporte une nappe en matière élastique dans laquelle sont moulées des touches dudit équipement, ledit dispositif de contact étant constitué par une languette réalisée dans ladite nappe et qui porte une ou plusieurs pistes de contact.

L'invention consiste donc à utiliser, pour réaliser le dispositif de contact, une nappe en matière élastique qui existe par ailleurs dans l'équipement (il s'agit ici de la nappe dans laquelle sont moulées les touches de l'équipement). L'invention permet ainsi de diviser par environ trois le coût du dispositif de contact.

De même, un dispositif selon l'invention, et tel que décrit dans le paragraphe introductif, est caractérisé en ce qu'il est constitué par une languette porteuse d'une ou plusieurs pistes de contact, qui est réalisée dans une nappe en matière élastique dudit équipement, dans laquelle sont moulées lesdites touches.

Et une nappe en matière élastique selon l'invention, et telle que décrite dans le paragraphe introductif, est caractérisée en ce qu'elle comporte une languette porteuse de pistes conductrices destinée à constituer un tel dispositif de contact.

D'autres détails et avantages de l'invention apparaîtront dans la description qui va suivre, en référence aux dessins annexés qui sont donnés à titre d'exemples non limitatifs, et dans lesquels:
- la figure 1 représente un équipement comportant un dispositif de contact selon l'art antérieur,
- la figure 2 représente une vue éclatée d'un exemple d'équipement selon l'invention,
- la figure 3 représente une vue en coupe d'une partie de l'équipement de la figure 2,
- la figure 4 représente une vue en coupe d'une partie d'un autre exemple d'équipement selon l'invention.

Sur la figure 2 on a représenté une vue schématique éclatée d'un exemple d'équipement selon l'invention, et sur la figure 3, on a représenté une vue en coupe d'une partie de ce même équipement. Les éléments communs aux deux figures portent les mêmes signes de référence.

L'équipement représenté sur les figures 2 et 3 est un téléphone mobile comportant notamment une coque en deux parties 100 et 101 et, à l'intérieur de cette coque, un circuit imprimé 102, une nappe 103 en élastomère dans laquelle sont moulées des touches 104 de l'équipement, un écran à cristaux liquides 110, et un dispositif de vitre 120 qui vient se placer sur l'écran 110. L'ensemble constitué par la vitre 120, l'écran 110, la nappe élastomère 103 et le circuit imprimé 102 est maintenu en place par deux clips 130 (seul l'un de ces clips est apparent sur la figure 2).

L'écran 110 comporte une face avant 131 et une face arrière 132, et une plage de contact 140 sur sa face arrière 132.

La nappe en matière plastique 103 comporte, en plus des touches 104, un support 145 pour l'écran 110 et une languette 150 dotée d'une face avant 151, d'une face arrière 152, d'une extrémité libre 153 et d'une extrémité fixe 154. La languette 150 porte plusieurs pistes de contact 155 sur sa face arrière 152. Lorsque la nappe 103 repose sur le circuit imprimé 102 les pistes 155 sont en contact avec une zone de contact 160 du circuit imprimé 102. Pour établir le contact électrique entre le circuit imprimé 103 et l'écran 104, la languette 150 est repliée vers l'écran et elle est introduite par une fente 170 du dispositif de vitre 120 de façon à ce que sa face arrière 152 soit en contact avec la zone de contact 140 de l'écran. Ainsi, la pression nécessaire pour établir le contact électrique entre l'écran 110 et le circuit imprimé 102 est assurée par le dispositif de vitre 120 qui est maintenu par les clips 130.

Le dispositif de contact selon l'invention est donc constitué par les zones de contact 140 et 160, la languette 150 et ses pistes de contact 155 et le dispositif de vitre 120 qui assure la pression.

Dans un premier mode de réalisation de l'invention, les pistes de contact 155 de la languette 150 sont gravées sur la languette avec de l'encre conductrice. Dans un second mode de réalisation de l'invention, elles sont constituées par de fines lamelles métalliques sur lesquelles la matière élastique constituant la languette a été coulée. Ce second mode de réalisation présente l'avantage d'être particulièrement robuste. Il est donc utilisé de façon préférentielle lorsque la languette doit être repliée pour assurer le contact comme c'est le cas sur les figures 2 et 3, afin d'éviter d'éventuelles micro-coupures des pistes dues au pliage de languette.

Le fait que la languette 150 soit repliée pour assurer le contact est lié à la configuration de l'équipement et à la disposition, les uns par rapport aux autres, des différents éléments qu'il contient. Avec d'autres formes d'équipement ou d'autres dispositions de ces éléments, la languette ne serait pas nécessairement repliée. A titre d'exemple, on a représenté schématiquement sur la figure 4, un équipement selon l'invention dans lequel la languette n'est pas repliée. Dans l'équipement de la figure 4, l'écran 210 comporte une face avant 231, une face arrière 232, et une plage de contact 240 sur sa face avant 231. Un support 245 est prévu pour l'écran 210. Ce support est par exemple constitué par un bloc de mousse. La nappe élastomère 203 porte des touches 204 et une languette 250 dotée d'une face avant 251 et d'une face arrière 252. La languette 250 porte plusieurs pistes de contact 255 sur sa face arrière 252. Ces pistes 255 sont en contact avec la zone de contact 260 du circuit imprimé 202. Pour établir le contact électrique entre l'écran et le circuit imprimé, la languette 250 est introduite par une fente 270 d'un dispositif de vitre 220, de telle sorte que sa face arrière 252 soit en contact avec la plage de contact 240 de l'écran. Le dispositif de vitre 220 est maintenu en place sur le circuit imprimé par des clips non représentés de telle sorte que la pression entre les surfaces de contact (plage de contact 240 / pistes 255 d'une part et pistes 255 / zone de contact 260 d'autre part) soit assurée.

L'homme du métier peut imaginer bien d'autres variantes des modes de réalisation qui viennent d'être décrits, par exemple un équipement dans lequel l'écran et les touches se trouvent sur des faces opposées.

## Revendications

1. Equipement électronique comportant un écran à cristaux liquides (110, 210), un circuit imprimé (102, 202) et un dispositif de contact électrique entre ledit écran et ledit circuit imprimé, caractérisé en ce qu'il comporte une nappe (103, 203) en matière élastique dans laquelle sont moulées des touches (104, 204) dudit équipement, ledit dispositif de contact étant constitué par une languette (150, 250) réalisée dans ladite nappe et qui porte une ou plusieurs pistes de contact (155, 255).

2. Equipement selon la revendication 1, caractérisé en ce que ladite ou lesdites pistes de contact sont gravées sur ladite languette avec de l'encre conductrice.

3. Equipement selon la revendication 1, caractérisée en ce que ladite ou lesdites pistes de contact sont constituées par de fines lamelles métalliques sur lesquelles la matière élastique constituant la languette a été coulée.

4. Equipement selon la revendication 1, caractérisé en ce que ladite languette étant dotée d'une extrémité libre (153) et d'une extrémité fixe (154), et ledit circuit imprimé (102) et ledit écran (110) étant chacun dotés de zones de contact (160 et 140 respectivement), l'extrémité libre (153) de ladite languette est placée en regard de la zone de contact (140) dudit écran, et son extrémité fixe (154) est placée en regard de la zone de contact (160) dudit circuit imprimé, le contact électrique étant assuré par au moins un dispositif mécanique de pression (120).

5. Dispositif destiné à établir un contact électrique entre un écran à cristaux liquides (110, 210) et un circuit imprimé (102, 202) d'un équipement électronique doté de touches (104, 204), caractérisé en ce qu'il est constitué par une languette (150, 250) porteuse d'une ou plusieurs pistes de contact (155, 255), qui est réalisée dans une nappe (103, 203) en matière élastique dudit équipement, dans laquelle sont moulées lesdites touches.

6. Nappe (103, 203) en matière élastique dans laquelle sont moulées des touches (104, 204), et qui est destinée à être utilisée dans un équipement électronique qui comporte un écran (110, 210) et un circuit imprimé (102, 202) reliés par un dispositif de contact électrique, caractérisée en ce qu'elle comporte une languette (150, 250) porteuse de pistes conductrices (155, 255) destinée à constituer un tel dispositif de contact.
